Europäisches Patentamt

(19) European Patent Office

Office européen des brevets

(11) Publication number : **0 454 317 B1**

# (12) EUROPEAN PATENT SPECIFICATION

(45) Date of publication of patent specification :
09.11.94 Bulletin 94/45

(51) Int. Cl.⁵ : **H05K 13/04,** H05K 13/00,
H05K 13/08

(21) Application number : **91303134.0**

(22) Date of filing : **09.04.91**

(54) **Method and apparatus for positioning a mounting head of chip component mounting device.**

(30) Priority : **27.04.90 JP 110129/90**

(43) Date of publication of application :
**30.10.91 Bulletin 91/44**

(45) Publication of the grant of the patent :
**09.11.94 Bulletin 94/45**

(84) Designated Contracting States :
**CH DE FR LI NL**

(56) References cited :
**EP-A- 0 049 350**
**EP-A- 0 248 904**
**US-A- 4 459 743**

(73) Proprietor : **JUKI CORPORATION**
**8-2-1, Kokuryo-machi**
**Chofu-shi**
**Tokyo (JP)**

(72) Inventor : **Taguchi, Katsuhiko**
**c/o JUKI CORPORATION,**
**8-2-1, Kokuryo-cho**
**Chofu-shi, Tokyo (JP)**

(74) Representative : **Johnson, Terence Leslie et al**
**Edward Evans & Co.**
**Chancery House**
**53-64 Chancery Lane**
**London WC2A 1SD (GB)**

## Description

This invention relates to a method and apparatus for positioning a mounting head of a chip component device, and more particularly to a control of a mounting head of a chip component mounting device, which is adapted so that the mounting head carried on a belt to be driven by a drive motor is controlled to pick up chip components for mounting the latter in a predetermined position on a substrate. Such an apparatus is disclosed in EP-A-0 248 904.

A chip component mounting device has been heretofore fabricated so that the mounting head is normally supplied with a vacuum pressure and takes advantage thereof to suck the chip components fed from a chip supply station which is so called the "feeder". The mounting head is then moved by a motor in X-Y directions to mount the chip components in a predetermined position on the substrate. In this instance, the mounting head is disposed on a belt trained between a drive pulley connected to the motor and a driven pulley provided apart from the drive pulley at a certain distance and is moved thereby in the X-Y directions. Otherwise, two sets of ball screws and nuts are provided to move the mounting head in X-Y drives, thereby positioning the head.

The belt which has been used in the aforementioned device is generally so called "timing belt" and is designed with a relatively high degree of accuracy. However, the head if moved to a great extent increases errors depending upon expansion or contraction of the belt. Consequently, for location of the mounting head, there is a difference in position between one case where the mounting head is advanced and another case where the mounting head is retracted. This difference may be in term of the value of ranging from 50 μm to 100 μm with head movement per about 500 mm. On the other hand, a chip component to be mounted by a chip component mounting device of this class is made in a micro size. Similarly, an integrated circuit element to be mounted by the mounting device is fabricated so that a pitch of a lead section is made very microscopic. For this reason, if the errors arise due to expansion or contraction of the timing belt as aforementioned, difficulties are involved in precisely mounting chip components.

Although when the mounting head is driven by use of the balls and nuts. there is very few errors as compared with the belt drive, this renders a drive mechanism for the ball screws and nuts complicated to result in a high cost and requires so much careful attention to assembling as not to impose radial load to the screws. Further, the balls have a disadvantage in a noise generated due to friction sound when the mounting head is driven at a high speed.

In view of what has discussed hereinbefore, the present invention is provided to eliminate the aforementioned disadvantages.

It is a prime object of the invention to provide a method and apparatus for positioning a mounting head of a chip component mounting device, which is capable of precisely mounting the mounting head in a predetermined position whatever a belt may expand or contract when the mounting head is driven and controlled by the belt.

The problem as above referred to is solved by a provision of a method for positioning a mounting head of a chip component mounting device wherein a head carried on a belt which is driven by a drive motor is controlled to pick up and mount a plurality of chip components in a predetermined position on a substrate, the method being composed of the steps of training the belt between a drive pulley connected to the drive motor and a driven pulley, measuring what difference in a rotational amount is between the drive pulley and the driven pulley, compensating slippage or deviation of the mounting head, which is derived from expansion or contraction of the belt according to the difference in the measured rotational amount between the pulley.

The problem is also solved by a provision of an apparatus for positioning a mounting head of a chip component mounting device wherein a mounting head carried on a belt which is driven by a drive motor is controlled to pick up and mount a plurality of chip components in a predetermined position on a substrate, comprising a drive pulley connceted to a drive motor, a driven pulley disposed apart from said drive pulley and adapted for rotation by said belt, means for detecting the rotational amount of the drive pulley, and means for compensating slippage or deviation of the mounting head, which is derived from expansion or contraction of the belt according to the difference in the rotational amount between the pulleys.

With this arrangement, the belt which carries the mounting head is trained between the two pulleys such as drive and driven pulleys and is driven thereby, viz. the former connected to the the drive motor and the latter disposed apart from the drive pulley at which time a difference in the rotational amount between the two pulleys is measured. The rotational amount of the drive pulley is the desired rotational amount when the mounting head is moved whereas the rotational amount of the driven pulley is indicative of the actual rotational amount in which the driven pulley is driven by the desired rotational amount. If the belt is made highly rigid, there is a little difference in the rotational amount. However, if the belt is expanded, the rotational amount the driven pulley do not correspond to the desired rotational amount but provides a big difference in the rotational amount. Accordingly, a difference in the rotational amount between the drive and the driven pulleys is indicative of slippage of the mounting head out of a predetermined position. In view thereof, according to the present invention, the difference in the rotational amount is measured to compensate slippage of the mounting head out of position, which is derived from expansion or contraction of the belt. This allows precise positioning of the mounting head even if the belt is expanded or contracted.

The present invention will become apparent from the following detailed description of the invention when considered in conjunction with the accompanying drawings in which:

Fig. 1 is a perspective view schematically showing an apparatus accoring to the present invention;

Fig. 2 is a block diagram showing a belt drive mechanism adapted for driving a mounting head;

Fig. 3 is a block diagram showing functions performd in a CPU (central processing unit);

Fig. 4 is a flow chart showing a control sequence of the instant apparatus; and,

Fig. 5 is a representation explanatory of slippage of the mounting head out of position, that is, a difference between the original position and the present position.

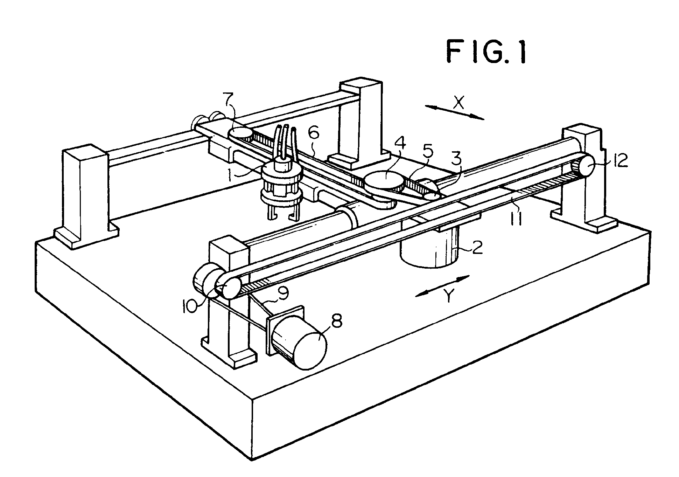

Referring to Fig. 1, a chip component mounting device embodying the present invention is shown in general illustration. Numeral 1 designates a mounting head which normally takes advantage of vacuum pressure to suck chip components fed from a chip supply station (not shown). The mounting head 1 is carried in position on an X-direction belt 6 which is trained between a drive pulley 4 and a driven pulley 7. The drive pulley 4 is driven from an X-direction motor 2 through a belt 5 trained between a motor pulley 3 and the drive pulley 4. Thus, drive of the motor 2 allows the belt 5 to rotate the drive pulley 4 to move the X-direction belt 6, thereby moving the mounting head 1 in the drection of an arrow X.

A mechanism (such as the X direction motor 2 or the like) for moving the mounting head in the direction of the arrow X is mounted in position on a Y-direction belt 11 which is trained between a drive pulley 10 and a driven pulley 12. When the drive pulley 10 is rotated from a Y-direction motor 8 through a belt 9 to move the belt 11, that is, the mounting head 1 is moved in the diretion of the arrow Y. In this instance, X and Y directon motors 2 and 8 are designed as a pulse motor or a servo motor.

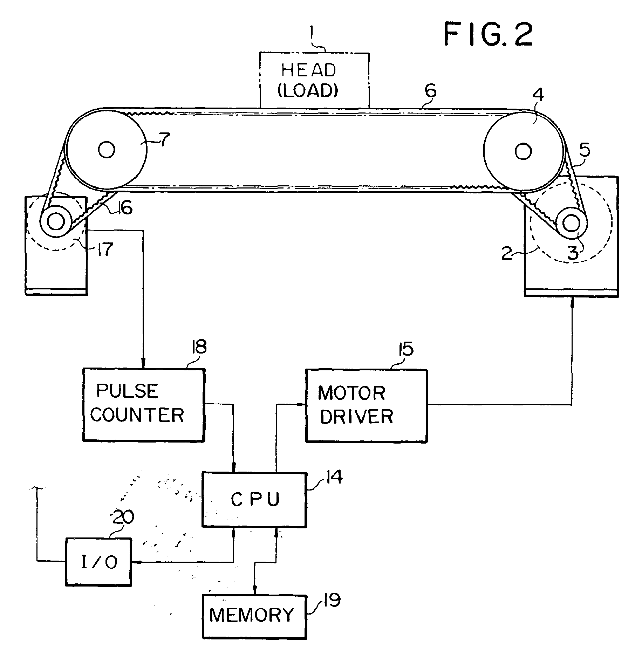

The X direction motor 2 is rotated at a predetermined rate by a motor driver 15 via a drive pulse outputted from a CPU 14 as shown in Fig. 2. A rotary encoder 17 is coupled by a belt 16 to the driven pulley 7. The output of the rotary encoder 17 is applied by a pulse counter 18 to the CPU 14. The CPU 14 is connected to a memory 19 and to an external equipment by an I/O 20.

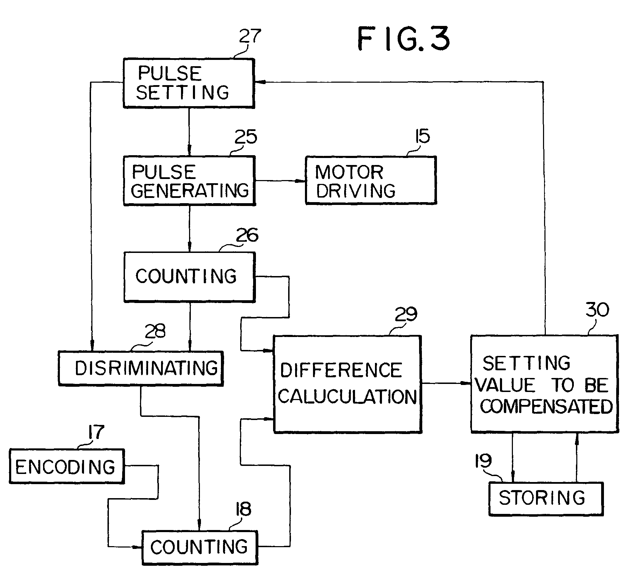

Fig. 3 is a block diagram which illustrates functions performd in the CPU shown in Fig. 2. The X direction motor 2 is driven by the motor driver 15 with a pulse from a pulse generator 25 and at the same time, the number of the pulses is counted by a counter 26. The number of pulses as set by a pulse setting circuit 27 and the number of pulses as counted by the counter 26 are discriminated by a discriminating circuit 28 to conclude that the pulse as prescribed is outputted to the motor driver 15 by coincidence of the number of both pulses so that the pulse from the encoder 17 is inputted to the counter 18. A difference arithmetic circuit 29 serves to compare the calculated value of the counter 18 with that of the counter 26 to correct the number of pulses as set with set pulse numbers by means of a unit 30 for setting the correction.

The operation of the instant apparatus arranged as aforesaid will be apprarent from the following description.

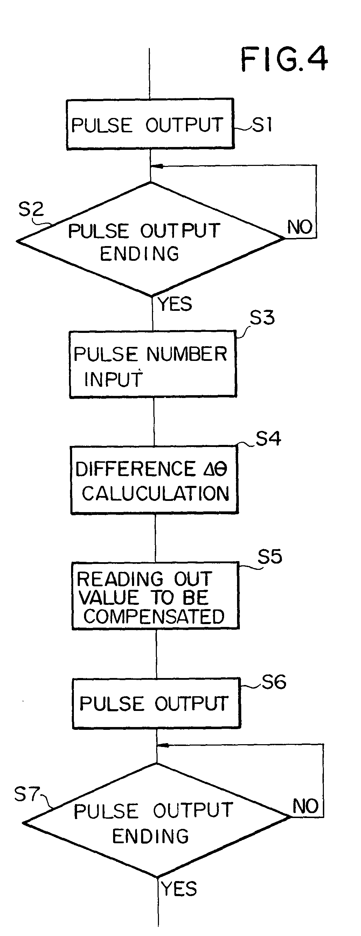

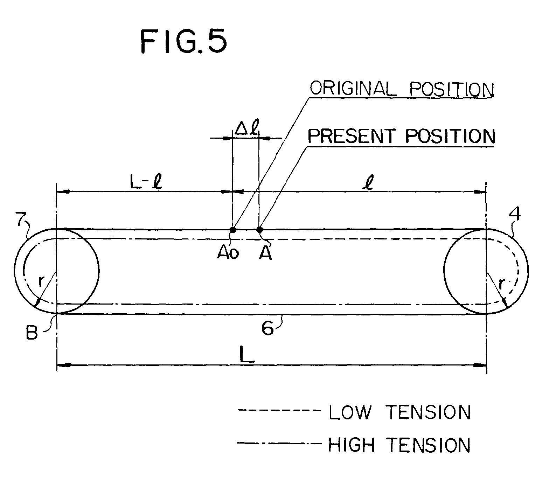

As seen from the flow chart of Fig. 4, the number of pulses corresponding to the extent of movement as set by the pulse setting circuit 27 is outputted to the X direction motor 2 by the motor driver 15 to move the chip mounting head (Step 1). This will continue until the value calculated by the counter 26 amounts to the number of pulses as set by means of the discrimination circuit 28 (Step S2). If this will have the mounting head held stationary at a point A as shown in Fig. 5, there would be a difference $\Delta\ell$ since the mounting head should be originally at a point $A_o$. This is a slippage of the mounting head out of the original position and renders the X-direction belt 6 tensioned (high tension) or slackened (low tension) as shown by the dot and dash line and the dotted line, respectively, of Fig. 5.

The length of the belt as high tensioned is expressed by:

$$L + (L - \ell) + \pi r$$
$$= 2L - \ell + \pi r \quad (1)$$

where L is the distance between the central axes of the pulleys, $\ell$ is the distance between the X direction motor 2 and the mounting head, and r is the radius each of the pulleys. In other words, the belt is tensioned to provide the difference $\Delta\ell$ so that the extent of elongation of the belt per unit length may be expressed by:

$$\Delta\ell / (2L - \ell + \pi r) \quad (2)$$

This derives the extent of slippage of the belt 6 at a point B (point of contact between the driven pulley 7 and the belt 6 ) may be formularized by:

$$\{L/(2L - \ell + \pi r)\} \cdot \Delta\ell \quad (3)$$

On the other hand, if an angular deviation of the driven pulley 7 (to be detected by the encoder 17), which is derived from slippage of the belt is put as $\Delta\theta$ , a tangential deviation of the pulley is expressed by the following equation from the formula (3) when $\Delta\theta \cdot r$ is held.

$$\Delta\theta \cdot r =$$
$$\{L/(2L - \ell + \pi r)\} \cdot \Delta\ell \quad (4)$$

This derives the slippage of the belt 6, which is formularized by:

$$\Delta \ell =$$
$$\{(2L - \ell + \pi r)/L\} \cdot \Delta\theta \cdot r \quad (5)$$

From the formula (5) where the distance L is between the central axes of the pulleys, and the radius r each of the pulleys is prescribed value, $\ell$ denoting the position where the head is driven, $\Delta$ is to be known. As $\Delta\theta$ may be inputted from the encoder, the slippage $\Delta\ell$ is obtained by perfoming calculations. Compensation for the deviation of the position may be made by dividing $\Delta\ell$ by the raduis r of each of the pulleys and rotating the motor 2.

In this case, if the units are found in terms of the values, where the distance L between the axises of the pulleys = 500mm, the diameter each of the pulley = 20mm, the resolution of encoder = 2,000 pulse/per rotation, and the reduction ratio of the driven pulley to the encoder = 1:4, the distance of the encoder 17 per one pulse on the side of the driven pulley 7 becomes 7.85μm. As previously set forth, the distance L between the axes of the pulleys is 500mm to provide the slippage in the order of 50-100 μm to afford full detection power. Supposing that the mounting head comes to a standstill at the central position ( $\ell$ =2/L=250mm) and a difference in pulses is 5 pulses from the encoder, the deviation of the position at the point A becomes 61 μm and is compensated by rotating the motor.

Referring back to the flow chart of Fig. 4, the number of pulses from the encoder 17d (Step S3) is inputted to the counter 18. Next, a differece between the number of output pulses and the number of input pulses from the encoder, that is, the aforementioned $\Delta\theta$ is calculated by means of the arithmetic circuit 29 upon adopting a difference in the counted values between the counter 26 and 18. (Step S4). The value to be compensated, which is stored in the memory 19 (ROM, RAM) is read from the difference in the pulses and the position $\ell$ (Step S5) to set the number of pulses to be compensated to a pulse setting circuit 27 by a circuit 30 for setting the value to be compensated. The pulse setting circuit 27 serves to output the number of pulses to be compensated to the motor driver 15 (Step S6). Completion of the output of pulse to be compensated is determined by (Step S7).

It is noted that the value to be compensated is not applied to the memory 19 in (Step 5) but may be calculated in CPU 14 by use of the fromula (5) as often as the case may be.

By application of the method according to the invention, it is ready to ascertain whether the belt is broken due to phenomena such as a difference in pulse trains of the encoder on the side of the driven pulley, expansion or contractraction derived from passage of time and ambient temperature, foreign matter interposed between the belt and the pulley, thereby ensuring that nothing is wrong.

Although the compensation obtained from the formula (5) has been made by the drive pulley in this instance, this may also be made by use of the movable elements (fine adjustders such as the motor and piezoelectric element and the like) disposed on the mounting head 1.

As is apparent from the formula (5), the closer the mounting head (load) is to the drive pulley 4, the greater (maximun about twice) the value to be compensated is relative to the error in the output pulse of the encoder on the side of the driven pulley. In contrast, the closer the mounting head is to the driven pulley 7, the smaller the compensation is relative to the aforementioned error. The location of the mounting head is not, however, incorporated in the formula (5). Instead, the compensation is made by only using the output pulse of the encoder on the side of the driven pulley to obtain the same effect or result. Otherwise, the value substantially approximate to the value obtained from the formula (5) may be mapped into the memory 19 to perform the same effect or result.

## Claims

1. An apparatus for positioning a mounting head of a chip component mounting device comprising:

    a drive motor (2, 8),

    a drive pulley (4, 10) connected to said drive motor,

    a driven pulley (7, 12) driven by said drive pulley,

    a belt (6, 11) between said drive pulley and said driven pulley, said belt mounting thereon the mounting head (1) for picking up a chip to mount the same on a substrate, wherein said mounting head may be out of position due to expansion or contraction of said belt,

    first sensing means (25, 26) for sensing rotation amount of said drive pulley,

    second sensing means (17) for sensing rotation amount of said driven pulley, and

    means (19, 30, 15) responsive to difference between said rotation amount of said drive pulley and rotation amount of said driven pulley for compensating position of said mounting head.

2. An apparatus for positioning a mounting head of a chip component mounting device according to claim 1 wherein

    said drive motor comprises a pulse motor (2, 8) and a pulse generator (25),

    said first sensing means (25, 26) comprises a counter (26) for counting the number of pulse generated from said pulse generator, and

    said second sensing means (17) comprises a rotary encoder (17) connected to said driven pulley and a counter (18) for counting the number of pulse generated from said rotary encoder.

3. An apparatus for positioning a mounting head of a chip component mounting device according to claim 1 wherein said compensating means (19, 30, 15) comprises:

means (29) for determining difference of said rotation amount of said drive pulley and rotation amount of said driven pulley,

means (19, 30) responsive to said difference of said rotation amount of said drive pulley and rotation amount of said driven pulley for determining correct position of said mounting head, and

means (15) responsive to said second determining means (19, 30) for driving said drive pulley to move said mounting head in correct position.

4. In a chip component mounting device having a belt (6, 11) between a drive pulley (4, 10) and a driven pulley (7, 12) and a mounting head (1) on said belt, wherein said mounting head may be out of position due to expansion or contraction of said belt, the method for positioning said mounting head comprising the steps of:

measuring the difference of the rotation amount of said drive pulley and the rotation amount of said driven pulley, and

moving said mounting head in response to said difference between said rotation amount of said drive pulley and said rotation amount of said driven pulley to correct the position of said mounting head.

**Patentansprüche**

1. Apparat, um einen Montagekopf eines Chip-Komponenten-Montiergerätes einzustellen, mit :

einem Antriebsmotor (2, 8),

einem Antriebsrad (4, 10), das mit diesem Antriebsmotor verbunden ist,

einem angetriebenen Rad (7, 12), das durch das genannte Antriebsrad angetrieben wird,

einem Band (6, 11) zwischen dem genannten Antriebsrad und dem genannten angetriebenen Rad, wobei das genannte Band den Antriebskopf darauf montiert trägt, um ein Chip zu nehmen und dasselbe auf ein Substrat zu montieren, wobei der genannte Montagekopf aus der Position liegen kann, wegen einer Ausdehnung oder einer Schrumpfung des genannten Bandes,

ersten Messmittel (25, 26), um den Drehungsgrad des genannten Antriebsrades zu messen,

zweiten Messmittel (17), um den Drehungsgrad des genannten angetriebenen Rades zu messen, und

Mittel (19, 30, 15), die auf eine Differenz zwischen dem genannten Drehungsgrad des genannten Antriebsrades und dem Drehungsgrad des genannten angetriebenen Rades ansprechen, um die Position des genannten Montagekopfes zu kompensieren.

2. Apparat gemäss Anspruch 1, um einen Montagekopf eines Chip-Komponenten-Montiergerätes einzustellen, in dem der genannte Antriebsmotor einen Impulsmotor (2, 8) und einen Impulsgenerator (25) besitzt, die genannten ersten Messmittel (25, 26), einen Zähler (26) aufweisen, um die Anzahl der durch den Impulsgenerator ausgelösten Impulse zu zählen, und die genannten zweiten Messmittel (17) ein drehendes Kodiergerät (17) aufweisen, das an dem genannten angetriebenen Rad angeschlossen ist und einen Zähler (18), um die Zahl der von diesem drehenden Kodiergerät abgegebenen Impulse zu zählen.

3. Apparat gemäss Anspruch 1, um einen Montagekopf eines Chip-Komponenten-Montiergerätes einzustellen, in dem die genannten Kompensiermittel (19, 30, 15)

Mittel (29), um die Differenz zwischen dem genannten Drehungsgrad des genannten Antriebsrades und dem Drehungsgrad des genannten angetriebenen Rades zu bestimmen,

Mittel (19, 30), die auf die genannte Differenz zwischen dem genannten Drehungsgrad des genannten Antriebsrades und dem Drehungsgrad des genannten angetriebenen Rades ansprechen, um die korrekte Position des genannten Montagekopfes zu bestimmen, und

Mittel (15), die auf die genannten zweiten bestimmenden Mittel (19, 30) ansprechen, um das genannte Antriebsrad anzutreiben, um den genannten Montagekopf in die korrekte Position zu bringen, aufweisen.

4. In einem Chip-Komponenten-Montiergerät mit einem Band (6, 11) zwischen einem Antriebsrad (4, 10) und einem angetriebenen Rad (7, 12), und mit einem Montagekopf auf dem genannten Band, in dem der genannte Montagekopf ausserhalb der Position wegen der Ausdehnung oder der Schrumpfung des genannten Bandes liegen kann, das Verfahren, um den genannten Montagekopf einzustellen, mit folgenden Schritten : die Differenz des Drehungsgrades des genannten Antriebsrades und des Drehungsgrades des genannten angetriebenen Rades messen und den genannten Montagekopf auf die Differenz zwischen dem genannten Drehungsgrad des genannten Antriebsrades und dem genannten Drehungsgrad des genannten angetriebenen Rades bewegen, um die Position des genannten Montagekopfes zu korrigieren.

## Revendications

1. Appareil pour positionner une tête de montage d'un dispositif de montage de puces intégrées comprenant :

un moteur d'entraînement (2, 8),

une poulie d'entraînement (4, 10) connectée audit moteur d'entraînement,

une poulie entraînée (7, 12) entraînée par ladite poulie d'entraînement,

une courroie (6, 11) entre ladite poulie d'entraînement et ladite poulie entraînée, ladite tête de montage (1) étant montée sur ladite courroie pour prendre une puce intégrée pour monter celle-ci sur un substrat, ladite tête de montage pouvant être hors position à cause de la dilatation ou de la contraction de ladite courroie,

des premiers moyens détecteurs (25, 26) pour détecter le degré de rotation de ladite poulie d'entraînement,

des deuxièmes moyens détecteurs (17) pour détecter le degré de rotation de ladite poulie entraînée, et

des moyens (19, 30, 15) répondant à une différence entre ledit degré de rotation de ladite poulie d'entraînement et le degré de rotation de ladite poulie entraînée pour compenser la position de ladite tête de montage.

2. Appareil pour positionner une tête de montage d'un dispositif de montage de puces intégrées selon la revendication 1, dans lequel :

ledit moteur d'entraînement comprend un moteur à impulsions (2, 8) et un générateur d'impulsions (25),

lesdits premiers moyens détecteurs (25, 26) comprennent un compteur (26) pour compter le nombre d'impulsions générées par ledit générateur d'impulsions et,

lesdits seconds moyens détecteurs (17) comprennent un codeur tournant (17) connecté à ladite poulie entraînée et un compteur (18) pour compter le nombre d'impulsions générées par ledit codeur tournant.

3. Appareil pour positionner une tête de montage d'un dispositif de montage de puces intégrées selon la revendication 1, dans lequel lesdits moyens de compensation (19, 30, 15) comprennent :

des moyens (29) pour déterminer une différence entre ledit degré de rotation de ladite poulie d'entraînement et le degré de rotation de ladite poulie entraînée,

des moyens (19, 30) répondant à ladite différence dudit degré de rotation de ladite poulie d'entraînement et le degré de rotation de ladite poulie entraînée pour déterminer la position correcte de ladite tête de montage et,

des moyens (15) répondant auxdits seconds moyens de détermination (19, 30) pour entraîner ladite poulie d'entraînement pour déplacer ladite tête de montage dans une position correcte.

4. Dans un dispositif de montage de puces intégrées possédant une courroie (6, 11) entre une poulie d'entraînement (4, 10) et une poulie entraînée (7, 12) et une tête de montage (1) sur ladite courroie, où ladite tête de montage peut être hors position à cause de la dilatation ou de la contraction de ladite courroie, le procédé de positionnement de ladite tête de montage comprenant les étapes :

mesurer la différence du degré de rotation de ladite poulie d'entraînement et le degré de rotation de ladite poulie entraînée et déplacer ladite tête de montage en réponse à ladite différence entre ledit degré de rotation de ladite poulie d'entraînement et ledit degré de rotation de ladite poulie entraînée pour corriger la position de ladite tête de montage.

# FIG.1

FIG.2

## FIG.3

PULSE SETTING 27

PULSE GENERATING 25

MOTOR DRIVING 15

COUNTING 26

DISRIMINATING 28

ENCODING 17

COUNTING 18

DIFFERENCE CALUCULATION 29

SETTING VALUE TO BE COMPENSATED 30

STORING 19

# FIG.4

PULSE OUTPUT — S1

S2 — PULSE OUTPUT ENDING — NO

YES

S3 — PULSE NUMBER INPUT

S4 — DIFFERENCE Δθ CALUCULATION

S5 — READING OUT VALUE TO BE COMPENSATED

S6 — PULSE OUTPUT

S7 — PULSE OUTPUT ENDING — NO

YES

# FIG.5

ORIGINAL POSITION

PRESENT POSITION

---------- LOW TENSION

—-—-—-— HIGH TENSION